# FASCICULE DE BREVET EUROPEEN

(11) **EP 2 434 034 B1**
(45) Date de publication et mention de la délivrance du brevet: **30.01.2013**
(21) Numéro de dépôt: 11306078.4
(22) Date de dépôt: 29.08.2011
(51) Int. Cl.: B82Y 40/00, C30B 29/60, C30B 33/08, H01L 29/06, H01L 21/02

(54) **Procédé pour éliminer les résidus de catalyseur métallique à la surface de nano-fils**
Verfahren zur Entfernung von metallischen Katalysatorenresten aus Nanodrahtoberfläche
Method for removing metallic catalysor remains from the surface of nanowires

(30) Priorité: 22.09.2010 FR 1057595
(43) Date de publication de la demande: 28.03.2012
(73) Titulaire: COMMISSARIAT A L'ENERGIE ATOMIQUE ET AUX ENERGIES ALTERNATIVES, 75015 Paris (FR)
(72) Inventeur: Perraud, Simon, 83150 Bandol (FR); Coronel, Philippe, 38530 Barraux (FR)
(74) Mandataire: Vuillermoz, Bruno

(56) Documents cités:
- US-A1- 2006 225 162
- WHANG S J ET AL: "Complementary metal-oxide-semiconductor compatible Al-catalyzed silicon nanowires", ELECTROCHEMICAL AND SOLID-STATE LETTERS 2007 ELECTROCHEMICAL SOCIETY INC. US, vol. 10, no. 6, 2007, pages 11-13, XP002635001, DOI: DOI:10.1149/1.2716304
- MING-CHE YANG ET AL: "Fabrication of silicon and germanium nanostructures by combination of hydrogen plasma dry etching and VLS mechanism", JAPANESE JOURNAL OF APPLIED PHYSICS, PART 1 (REGULAR PAPERS, SHORT NOTES & REVIEW PAPERS) JAPAN SOC. APPL. PHYS. JAPAN, vol. 44, no. 7B, 26 juin 2005 (2005-06-26) , pages 5791-5794, XP002635002, ISSN: 0021-4922, DOI: DOI:10.1143/JJAP.44.5791

## Description

### DOMAINE DE L'INVENTION

La présente invention propose un procédé pour éliminer les traces de résidus catalytiques présents à la surface des structures solides, notamment nano-fils, obtenus par croissance catalytique.

Ce procédé présente un intérêt tout particulier dans le domaine de l'électronique ou photovoltaïque, où la présence de catalyseur résiduel entraîne des dégradations significatives des performances des dispositifs concernés.

### ETAT ANTERIEUR DE LA TECHNIQUE

Des structures solides en forme de fils, de diamètre compris entre quelques nanomètres et quelques millimètres, peuvent être élaborées par croissance catalytique.

Le document Kolasinski *(*Current Opinion in Solid State and Materials Science 10, 182-191 (2006)) décrit différentes variantes de cette technologie notamment concernant :
- les mécanismes de croissance catalytique : vapeur-liquide-solide, vapeur-solide-solide, et solution-liquide-solide ;
- les types de fils : silicium, germanium, silicium-germanium, silice, alumine, semi-conducteurs de type II-VI, semi-conducteurs de type III-V...

Le catalyseur mis en oeuvre consiste généralement en des plots métalliques, réalisés par exemple en cuivre, or, platine ou aluminium, dont la taille contrôle en partie le diamètre des fils.

Ainsi, la croissance des nano-fils, par exemple de silicium, se fait à partir d'un catalyseur métallique sous forme de goutte. En injectant un gaz porteur de silicium, le fil croit sous le plot de métal et l'entraîne avec lui. Ainsi, la goutte de catalyseur reste au sommet du fil et doit ensuite être éliminée, notamment par gravure.

Par ailleurs, lors de la croissance catalytique de fils, des résidus de catalyseur métallique peuvent demeurer à la surface des fils. Ce phénomène est décrit, par exemple dans l'article de M. 1. den Hertog et al. (Nano Letters 8, 1544-1550 (2008)), dans le cas de fils de silicium élaborés par le mécanisme vapeur-liquide-solide avec une catalyse par l'or.

Or, les résidus de catalyseur métallique sont néfastes pour un grand nombre d'applications. Par exemple, pour des fils de silicium destinés à des applications en électronique ou en photovoltaïque, la présence de métaux tels que l'or ou le cuivre entraînent des dégradations significatives des performances des dispositifs, car ces métaux provoquent l'apparition de pièges électroniques profonds dans la bande interdite du silicium.

Une solution courante pour éliminer les résidus de catalyseur métallique à la surface des fils consiste à graver le métal, par attaque en voie humide ou en voie sèche, après croissance des fils.

Cependant, l'élimination des résidus de catalyseur métallique par gravure du métal est souvent d'une efficacité limitée. En particulier, pour les fils constitués de matériaux oxydables à l'air, comme c'est le cas du silicium, la gravure du métal peut être rendue inefficace par la formation, à la surface du fil, d'une couche d'oxyde.

Le document WHANG et al. (Electrochemical and Solid-State Letters 2007 Electrochemical Society Inc. US, vol. 10, no. 6, 2007, pages 11-13) décrit l'élimination du catalyseur par une attaque chimique sur le nanofil créé.

Le document YANG et al. (Japanese Journal of Applied Physics, Part 1 (regular papers, short notes & review papers) Japan Soc. Appl. Phys. Japan, vol. 44, no. 7B, 26 Juin 2005, pages 5791-57941 décrit la croissance de nanofils de silicium puis de nanofils de germanium en utilisant les restes de catalyseur sur le silicium, et enfin l'élimination du catalyseur.

Il existe donc un besoin évident de développer de nouvelles solutions techniques permettant d'éliminer les résidus de catalyseur présents à la surface, notamment au niveau du flanc, des structures solides en forme de fils élaborées par croissance catalytique.

### EXPOSE DE L'INVENTION

La présente invention propose un procédé pour éliminer les résidus de catalyseur métallique présents à la surface de fils, ou plus généralement de structures solides, élaborés par croissance catalytique. Un tel procédé s'avère plus efficace qu'une simple gravure du métal comme réalisé dans l'art antérieur.

En effet, dans la mesure où ces résidus sont en matériau catalyseur, il est proposé de faire croître des fils secondaires à partir de ces résidus. Ces fils secondaires doivent être en un matériau spécifique, facile à éliminer sans détériorer les fils principaux. En supprimant ces fils secondaires, on élimine les résidus emmenés de façon standard à l'extrémité libres de ces fils.

Plus précisément, l'invention concerne un procédé d'élimination des résidus de catalyseur présents à la surface de structures solides réalisées en un premier matériau et obtenues par croissance catalytique, qui comprend les étapes suivantes :
- croissance catalytique, à partir des résidus de catalyseur, de structures solides réalisées en un second matériau ;
- élimination sélective desdites structures solides réalisées en un second matériau.

La présente invention a donc trait à la croissance catalytique de structures solides, prenant la forme de fils, avantageusement de nano-fils (possédant de manière classique un diamètre inférieur à 500 nanomètres, de l'ordre de 100 nanomètres).

De manière connue pour l'homme du métier, cette technique consiste à faire croître, à partir d'un plot ou d'une goutte de catalyseur déposé sur un substrat, une structure solide réalisée en un matériau donné, et ce grâce à l'apport d'un précurseur dudit matériau, ce dernier pouvant être sous forme gazeuse, liquide ou solide (Cf. Kolasinski).

Le catalyseur est avantageusement métallique, encore plus avantageusement choisi dans le groupe suivant : cuivre, or, platine et aluminium.

De manière également connue, la croissance de la structure se fait sous le catalyseur et la structure entraîne le catalyseur essentiellement à son sommet (à son extrémité libre), avec des résidus sur ses flancs, c'est-à-dire sur les surfaces parallèles à l'axe de croissance.

L'élimination du catalyseur au sommet de la structure se fait traditionnellement par gravure, c'est-à-dire par un procédé chimique ou électrochimique permettant l'attaque sélective du catalyseur. Le procédé selon l'invention permet plus généralement et plus efficacement d'éliminer tout résidu de catalyseur présent à la surface de la structure solide réalisé dans le premier matériau, qui pourra être appelée, dans la suite de l'exposé, fil principal.

Ainsi, il s'agit d'utiliser les résidus de catalyseur présents à la surface de la structure principale pour assurer la croissance catalytique de structures solides réalisées en un second matériau, qui pourront être appelées, dans la suite de l'exposé, fils secondaires ou sacrificiels.

Pour assurer cette croissance, les éléments suivants doivent être réunis :
- choisir un précurseur du second matériau dont la croissance peut être catalysée par le catalyseur ayant servi à la croissance du premier matériau ;
- apporter ce précurseur ;
- réunir les conditions nécessaires à la croissance catalytique (température, pression).

A nouveau, la croissance de ces structures secondaires va entraîner la migration des résidus de catalyseur à leur surface, notamment à leur sommet, c'est-à-dire à leur extrémité libre.

En pratique, dans la mesure où la taille des plots ou gouttes de catalyseur détermine en partie la taille ou diamètre des structures solides, notamment des fils, le diamètre du fil principal est préférentiellement supérieur au diamètre des fils sacrificiels. Typiquement, le diamètre des fils sacrificiels est avantageusement compris entre 1 nanomètre et 10 nanomètres, le diamètre du fil principal étant alors supérieur à 10 nanomètres.

A l'issue de cette croissance catalytique, les fils sacrificiels forment donc des branches sur le fil principal.

La seconde étape de ce procédé consiste en une élimination sélective desdites structures solides réalisées en un second matériau. En effet, leur élimination entraîne l'élimination concomitante des résidus de catalyseur et permet donc d'atteindre le but recherché. De manière privilégiée, cette élimination est complète, c'est-à-dire qu'à l'issue de cette étape, le second matériau et le catalyseur sont absents de la structure principale qui reste la seule en présence.

Comme déjà dit, un second critère important est la sélectivité de cette élimination. En effet, il faut réduire au maximum l'élimination du premier matériau constitutif de la structure solide principale.

Cette élimination sélective peut être réalisée par une approche physique, par exemple par bombardement ionique. Toutefois et de manière avantageuse selon l'invention, cette élimination est réalisée par gravure, attaque chimique qui peut aussi bien avoir lieu par voie humide que par voie sèche.

En d'autres termes, il faut choisir une solution chimique et des matériaux (premier et second) tels que la solution présente une vitesse d'attaque du second matériau supérieure à celle du premier matériau. Avantageusement, la vitesse d'attaque du premier matériau est inférieure à au moins 10 fois la vitesse d'attaque du second matériau.

Dans ces conditions, il est possible de graver entièrement les fils sacrificiels, tout en limitant la gravure du fil principal.

Dans le cadre de l'invention, le premier matériau constitutif de la structure principale et donc d'intérêt est avantageusement choisi dans le groupe suivant : silicium (Si), germanium (Ge), silicium-germanium (Si-Ge), silice (SiO₂), alumine (Al₂O₃), semi-conducteurs de type II-VI, semi-conducteurs de type III-V tels que l'arséniure de gallium (GaAs), encore plus avantageusement en silicium.

Ainsi et à titre d'exemple, si le premier matériau est du silicium (Si) et le catalyseur de l'or (Au), il peut être choisi du silicium-germanium Si-Ge, notamment du Si₁-ₓGeₓ avec x = 0,4, en tant que second matériau. L'élimination sélective peut alors être réalisée par attaque en voie humide dans une solution aqueuse d'acide fluorhydrique (HF), acide nitrique (HNO₃) et acide acétique (CH3COOH).

Alternativement, si le premier matériau est de l'arséniure de gallium (GaAs) et le catalyseur de l'or (Au), il peut être choisi de l'arséniure d'indium (InAs) en tant que second matériau. L'élimination sélective peut alors être réalisée par attaque en voie sèche à l'aide de chlorure d'hydrogène (HCl) gazeux.

Ainsi et selon un second aspect, la présente invention concerne également un procédé d'élaboration de structures solides réalisées en un premier matériau, qui comprend les étapes suivantes :
- croissance catalytique, à partir d'un catalyseur, desdites structures solides réalisées en un premier matériau ;
- élimination des résidus de catalyseur présents à la surface de structures solides grâce à la mise en oeuvre du procédé décrit ci-dessus.

Dans une étape intermédiaire, c'est-à-dire après l'étape de croissance catalytique des structures solides réalisées en un premier matériau, il est possible de réaliser une première élimination au moins partielle du catalyseur, avantageusement par gravure. Dans cette étape et comme déjà décrit par ailleurs, il est possible d'éliminer au moins partiellement le catalyseur qui a été entraîné à l'extrémité libre de la structure solide.

Ainsi, pour la première fois et avec une grande efficacité, la présente invention permet d'obtenir des structures solides, avantageusement des fils ou nano-fils, dépourvues de catalyseur à leur surface, et notamment sur leurs flancs, à savoir les surfaces parallèles à l'axe de croissance.

Comme déjà dit, ces structures solides sont avantageusement réalisées à l'aide des matériaux suivants : silicium (Si), germanium (Ge), silicium-germanium (Si-Ge), silice (SiO₂), alumine (Al₂O₃), semi-conducteurs de type II-VI, semi-conducteurs de type III-V tels que l'arséniure de gallium (GaAs), avantageusement en silicium.

En outre, ces nano-fils présentent avantageusement un diamètre supérieur à 10 nanomètres, et pouvant aller jusqu'à 500 nanomètres, encore plus avantageusement de l'ordre de 100 nanomètres.

### BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées parmi lesquelles :
La figure 1 présente un procédé d'élaboration de nano-fils par croissance catalytique selon l'art antérieur, comprenant une étape de croissance des nano-fils (A) suivie d'une étape de gravure (B).
La figure 2 présente le procédé d'élaboration de nano-fils par croissance catalytique selon l'invention, comprenant en outre une étape de croissance d'un second réseau de nano-fils (C) puis son élimination par gravure (D).

### EXEMPLES DE REALISATION DE L'INVENTION

### 1/Principe :

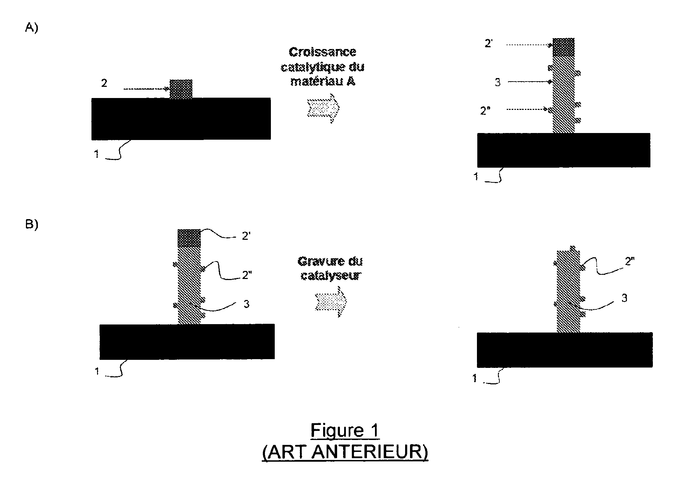

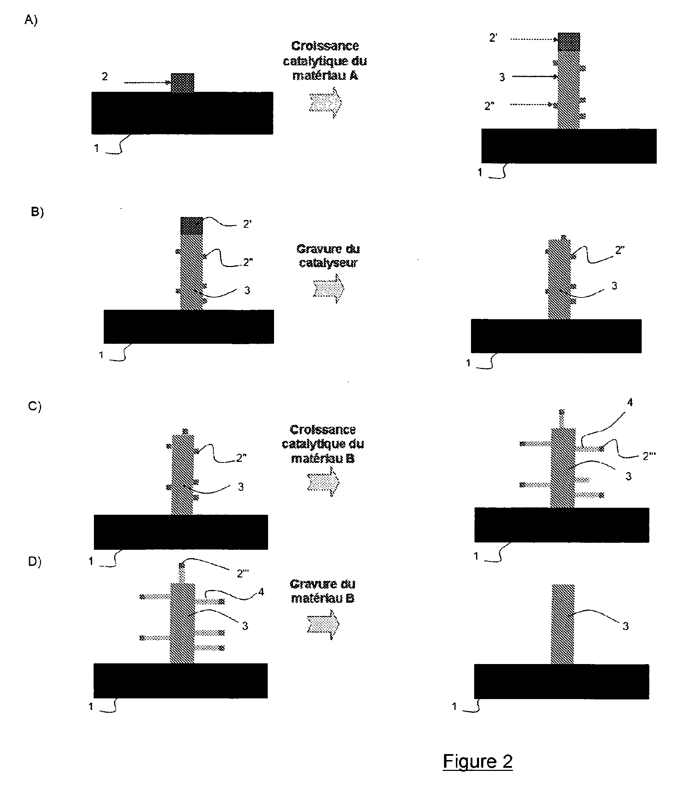

Le procédé selon l'invention, illustré à la figure 2, débute comme le procédé selon l'art antérieur illustré à la figure 1 :

### - Etape 1 (Fig. 1A ; Fig. 2A) :

Un plot de catalyseur métallique (2) est déposé à la surface d'un substrat (1). Grâce à l'apport d'un précurseur du matériau constitutif du fil principal (matériau A) et à l'aide d'un gaz vecteur choisi en fonction du précurseur, la croissance catalytique du fil principal (3) est assurée à la surface du substrat (1). Le fil (3) croît sous le plot de catalyseur (2) et l'emmène avec lui. A l'issue de cette croissance catalytique, le catalyseur (2') se trouve essentiellement au sommet du fil (3) mais des résidus de catalyseur (2") se trouvent également sur les flancs du fil (3).

### - Etape 2 (Fig. 1B ; Fig. 2B) :

Afin d'éliminer un maximum de catalyseur (2', 2"), celui-ci est gravé par attaque en voie humide ou en voie sèche. Cette étape permet certes d'éliminer le catalyseur (2') au sommet du fil (3). Toutefois, des résidus de catalyseur métallique (2") demeurent à la surface du fil principal (3). Cette étape est cependant facultative.

Le procédé selon l'invention prévoit deux étapes ultérieures successives permettant d'éliminer les résidus de catalyseur métallique (2") présents à la surface du fil principal (3) :

### - Etape 3 (Fig. 2C) :

Grâce à l'apport d'un précurseur d'un second matériau (B) et à l'aide d'un gaz vecteur, la croissance catalytique de fils dits sacrificiels (4) est assurés à la surface du fil principal (3), à partir des résidus de catalyseur métallique (2"). Les fils sacrificiels (4) croissent sous le catalyseur (2") et l'emmènent avec lui. A l'issue de cette croissance catalytique, le catalyseur (2"') se trouve au sommet des fils sacrificiels (4) qui forment des branches sur le fil principal (3).

### - Etape 4 (Fig. 2D):

Il est réalisé une gravure complète du matériau B, par attaque en voie humide ou en voie sèche, qui permet de se débarrasser des fils sacrificiels (4) et par là aussi des résidus de catalyseur métallique (2''').

A l'issue de ce procédé, les résidus de catalyseur métallique présents sur les flancs des fils d'intérêt et dont la gravure classique n'avait pas permis de se débarrasser ont donc été éliminés.

### 2/Exemple 1 :

### - Etape 1: croissance des nano-fils de silicum

Le fil principal (3) est un fil en silicium (Si = matériau A) de diamètre 100 nanomètres, élaboré à l'aide d'un catalyseur métallique en or (2). Les conditions opératoires sont les suivantes :
- nanoparticules colloïdales d'or (100 nm) sur substrat Si (111) ;
- T = 650 °C ;
- P = 10 mbar ;
- mélange SiH₄ (silane) + H₂ (hydrogène) ;
- durée : 20 mn.

### - Etape 2: gravure or

- solution commercialisée sous la référence « IKI2 » par la société VWR Prolabo, constituée par une solution aqueuse de KI (iodure de potassium) et d'iode I₂, à température ambiante ;
- durée : 10 mn.

### - Etape 3: croissance de nano-fils de silicium-germanium

Croissance catalytique de fils sacrificiels (4) en silicium-germanium. (Si₁₋ₓGeₓ avec x = 0,4), à partir des résidus d'or (2") présents à la surface du fil principal (3). Conditions opératoires suivantes :
- T=550°C;
- P = 10 mbar ;
- mélange SiH₄ (silane) + GeH₄ (germane) + H₂ (hydrogène), avec ratio [flux GeH₄/flux SiH₄] = 1,5 ;
- durée 10 mn.

### - Etape 4: gravure des nano-fils de silicium - germanium

Gravure sélective du silicium-germanium (= matériau B) constitutif des fils sacrificiels (4), par attaque en voie humide dans une solution aqueuse d'acide fluorhydrique (HF), acide nitrique (HNO₃) et acide acétique (CH3COOH).

Conditions opératoires :
- solution aqueuse de HF (acide fluorhydrique), HNO₃ (acide nitrique), CH₃COOH (acide acétique), à température ambiante ;
- durée : 10 mn.

### 3/Exemple 2 :

### - Etape 1: croissance de nano-fils de GaAs

Le fil principal (3) est un fil en arséniure de gallium (GaAs = matériau A) de diamètre 100 nm, élaboré à l'aide d'un catalyseur métallique en or (2).

Conditions opératoires :
- nanoparticules colloïdales d'or (100 nm) sur substrat GaAs (111) ;
- T = 450 °C ;
- P = 100 mbar ;
- mélange TMGa (trimethylgallium) + AsH₃ (arsine) ;
- durée : 20 mn.

### - Etape 2: gravure or

- solution commercialisée sous la référence « IKI2 » par la société VWR Prolabo, constituée par une solution aqueuse de KI (iodure de potassium) et d'iode I₂, à température ambiante ;
- durée : 10 mn.

### - Etape 3: croissance de nano-fils de InAs

Croissance catalytique de fils sacrificiels (4) en arséniure d'indium (InAs), à partir des résidus d'or (2") présents à la surface du fil principal (3).

Conditions opératoires suivantes :
- T = 450 °C ;
- P = 100 mbar ;
- mélange TMIn (trimethylindium) + AsH3 (arsine) ;
- durée 10 mn.

### - Etape 4: gravure des nano-fils de InAs

Gravure sélective de l'arséniure d'indium (= matériau B) constitutif des fils sacrificiels (4), par attaque en voie sèche à l'aide de chlorure d'hydrogène (HCl) gazeux à 300 °C pendant 10 minutes.

## Revendications

1. Procédé d'élimination des résidus de catalyseur (2) présents à la surface de structures solides en forme de fils, réalisées en un premier matériau (3) et obtenues par croissance catalytique, comprenant les étapes suivantes :
- croissance catalytique, à partir des résidus de catalyseur (2), de structures solides en forme de fils, réalisées en un second matériau (4) ;
- élimination sélective desdites structures solides en forme de fils, réalisées en un second matériau (4).

2. Procédé d'élimination des résidus de catalyseur selon la revendication 1, ***caractérisé* en ce que** les structures solides (3,4) en forme de fils sont des nano-fils.

3. Procédé d'élimination des résidus de catalyseur selon la revendication 1 ou 2, ***caractérisé* en ce que** le catalyseur (2) est un catalyseur métallique, avantageusement choisi dans le groupe comprenant le cuivre, l'or, le platine et l'aluminium.

4. Procédé d'élimination des résidus de catalyseur selon l'une des revendications précédentes, ***caractérisé* en ce que** le premier matériau est choisi dans le groupe comprenant le silicium, le germanium, le silicium-germanium, la silice, l'alumine, les semi-conducteurs de type II-VI, les semi-conducteurs de type III-V tels que l'arséniure de gallium, et avantageusement en silicium.

5. Procédé d'élimination des résidus de catalyseur selon l'une des revendications précédentes, ***caractérisé* en ce que** l'élimination sélective desdites structures solides en forme de fils, réalisées en un second matériau (4), est réalisée par gravure, par attaque en voie humide ou en voie sèche.

6. Procédé d'élimination des résidus de catalyseur selon l'une des revendications précédentes, ***caractérisé* en ce que** le second matériau présente une vitesse d'attaque chimique par une solution donnée supérieure à celle du premier matériau.

7. Procédé d'élaboration de structures solides en forme de fils, réalisées en un premier matériau (3), comprenant les étapes suivantes :
- croissance catalytique, à partir d'un catalyseur (2), desdites structures solides en forme de fils, réalisées en un premier matériau (3) ;
- élimination des résidus de catalyseur (2) présents à la surface des structures solides en forme de fils (3) grâce à la mise en oeuvre du procédé selon l'une des revendications 1 à 6.

8. Procédé d'élaboration de structures solides selon la revendication 7, ***caractérisé* en ce que**, après l'étape de croissance catalytique desdites structures solides en forme de fils, réalisées en un premier matériau (3), le catalyseur (2) est éliminé au moins partiellement par gravure.

## Claims

1. A method for eliminating the catalyst residues (2) present on the surface of solid structures in the form of wires, made from a first material (3) and obtained by catalytic growth, including the following steps:
- catalytic growth, from the catalyst residues (2), of solid structures in the form of wires made from a second material (4);
- selective elimination of said solid structures in the form of wires made from a second material (4).

2. The method for eliminating catalyst residues as claimed in claim 1, *wherein* the solid structures the form of wires (3, 4) are wires, and to advantage nanowires.

3. The method for eliminating catalyst residues as claimed in claim 1 or 2, *wherein* the catalyst (2) is a metal catalyst, to advantage chosen from the group that includes copper, gold, platinum and aluminum.

4. The method for eliminating catalyst residues as claimed in one of the previous claims, *wherein* the first material is chosen from the group that includes silicon, germanium, silicon-germanium, silica, alumina, type II-VI semi-conductors, type III-V semi-conductors such as gallium arsenide, and to advantage silicon.

5. The method for eliminating catalyst residues as claimed in one of the previous claims, *wherein* said solid structures in the form of wires made from a second material (4) are selectively eliminated by etching, using a wet process or dry process.

6. The method for eliminating catalyst residues as claimed in one of the previous claims, *wherein* the second material is chemically attacked by a given solution at a faster rate than the first material is attacked.

7. A method for developing solid structures in the form of wires made from a first material (3) including the following steps:
- catalytic growth, from a catalyst (2), of said solid structures in the form of wires made from a first material (3);
- elimination of the catalyst residues (2) present on the surface of solid structures in the form of wires (3) by means of using the method as claimed in one of claims 1 to 6.

8. The method for developing solid structures as claimed in claim 7, *wherein,* after the step of catalytic growth of said solid structures in the form of wires made from a first material (3), the catalyst (2) is at least partially eliminated by etching.

## Patentansprüche

1. Verfahren zur Entfernung von Katalysatorrückständen (2) an der Oberfläche von drahtförmigen festen Strukturen, die aus einem ersten Material (3) bestehen und durch katalytisches Wachstum erzielt werden, umfassend die folgenden Schritte:
- katalytisches Wachstum von drahtförmigen festen Strukturen, die aus einem zweiten Material (4) bestehen, ausgehend von den Katalysatorrückständen (2);
- selektive Entfernung der drahtförmigen festen Strukturen, die aus einem zweiten Material (4) bestehen.

2. Verfahren zur Entfernung von Katalysatorrückständen nach Anspruch 1, **dadurch gekennzeichnet, dass** es sich bei den drahtförmigen festen Strukturen (3, 4) um Nanodrähte handelt.

3. Verfahren zur Entfernung von Katalysatorrückständen nach Anspruch 1 oder 2, **dadurch gekennzeichnet, dass** der Katalysator (2) ein metallischer Katalysator ist, der vorteilhafterweise aus der Gruppe gewählt ist, die Kupfer, Gold, Platin und Aluminium umfasst.

4. Verfahren zur Entfernung von Katalysatorrückständen nach einem der vorhergehenden Ansprüche, **dadurch gekennzeichnet, dass** das erste Material aus der Gruppe gewählt ist, die Silicium, Germanium, Siliciumgermanium, Siliciumdioxid, Aluminiumoxid, die Halbleiter des Typs II-VI, die Halbleiter des Typs III-V wie Galliumarsenid, und vorteilhafterweise aus Silicium, umfasst.

5. Verfahren zur Entfernung von Katalysatorrückständen nach einem der vorhergehenden Ansprüche, **dadurch gekennzeichnet, dass** die selektive Entfernung der drahtförmigen festen Strukturen, die aus einem zweiten Material (4) bestehen, durch Ätzen, durch Nassätzen oder durch Trockenätzen erfolgt.

6. Verfahren zur Entfernung von Katalysatorrückständen nach einem der vorhergehenden Ansprüche, **dadurch gekennzeichnet, dass** das zweite Material eine Geschwindigkeit des chemischen Ätzens durch eine vorgegebene Lösung aufweist, die höher ist als diejenige des ersten Materials.

7. Verfahren zur Herstellung von drahtförmigen festen Strukturen, die aus einem ersten Material (3) bestehen, umfassend die folgenden Schritte:
- katalytisches Wachstum der drahtförmigen festen Strukturen, die aus einem ersten Material (3) bestehen, ausgehend von einem Katalysator (2);
- Entfernung der an der Oberfläche der drahtförmigen festen Strukturen (3) vorhandenen Katalysatorrückstände (2) durch die Durchführung des Verfahrens nach einem der Ansprüche 1 bis 6.

8. Verfahren zur Herstellung von festen Strukturen nach Anspruch 7, **dadurch gekennzeichnet, dass** nach dem Schritt des katalytischen Wachstums der drahtförmigen festen Strukturen, die aus einem ersten Material (3) bestehen, der Katalysator (2) mindestens teilweise durch Ätzen entfernt wird.
